# EUROPEAN PATENT SPECIFICATION

(11) **EP 0 419 586 B1**
(45) Date of publication and mention of the grant of the patent: **30.11.1994**
(21) Application number: 90901040.7
(22) Date of filing: 18.12.1989
(51) Int. Cl.: H01L 29/73, H01L 29/10

(54) **INTEGRATED CIRCUIT COMPRISING A VERTICAL TRANSISTOR**
INTEGRIERTE SCHALTUNG MIT EINEM VERTIKALEN TRANSISTOR
CIRCUIT INTEGRE A TRANSISTOR VERTICAL

(30) Priority: 16.12.1988 FR 8816641
(43) Date of publication of application: 03.04.1991
(73) Proprietor: Philips Electronics N.V., 5621 BA Eindhoven (NL); PHILIPS COMPOSANTS, 92150 Suresnes (FR)
(72) Inventor: LEDUC, Pierre, F-14880 Colleville-Montgomery (FR)
(74) Representative: Charpail, François
(86) International application number: PCT/NL89/00098
(87) International publication number: WO 90/07194

(56) References cited:
- EP-A- 0 228 748
- DE-B- 1 090 329

## Description

The invention relates to a semiconductor device comprising a semiconductor body having a major surface and having an integrated circuit having a vertical transistor comprising a collector region of a first conductivity type, a base region of a second conductivity type disposed on at least a part of the collector region and an emitter region composed of at least one zone of the first conductivity type included in a part of said base region and adjoining said major surface of the semiconductor body.

In known bipolar transistors, the inverse current amplification β_{I} defined as the ratio between the emitter current I_{E} and the base current I_{B} when the collector-base junction is forward biased is usually not very high.

However in certain applications, it is desirable to have available transistors having a high inverse current amplification β_{I} of, for example several tens. In that case, it is possible to improve the collector-emitter voltage V_{CEsat} of the transistor in saturation or, whilst utilizing the transistor in the inverse sense, to realize a multi-collector transistor.

The invention has for its object to provide for a semiconductor device comprising an integrated circuit with such a vertical transistor.

The invention is based on the recognition that, in case the overall thickness of the base is smaller than or equal to the diffusion length of the minority charge carriers in this region, the phenomena of injection of charge carriers obey quite different rules from those admitted by the conventional theories.

According to the invention a semiconductor device of the kind described in the opening paragraph is characterized in that the overall thickness of the base region is smaller than or equal to the diffusion length of the minority charge carriers in said base region, in that said base region comprises at least one base contacting zone having at least one contact area adjacent to the said at least one zone of the emitter region, said base contacting zone being covered by an isolating layer having a window, through which a contact is provided to said contact area, the ratio between the surface area of said base contacting zone and the surface area of said window being at least equal to 10, and in that said base contacting zone has a surface area smaller than 5 times the total surface area of said emitter region.

These dimensional ratios assure the realization of amplification values which are interesting in practice. More particularly, and paradoxically, said contact provides an improvement of the amplification which is more striking in proportion as its area in contact with the contacting zone is smaller.

According to a first embodiment, said contact area is surrounded by a single zone constituting the emitter region.

According to a second embodiment, the emitter region is composed of at least two zones facing each other and flanking at least one portion of the said base contacting zone.

As set out in claim 4 and according to a third advantageous embodiment, the base region has at least two base contacting zones and the emitter region has at least two pairs of zones, the two zones of each pair facing each other and flanking a different one of said base contacting zones.

According to a preferred embodiment, the base region comprises a plurality of branches linked by a central region with respect to said branches, each branch comprising a zone of the emitter region, while the base contact area is disposed in said central region.

The invention will be more clearly understood after reading the following description given by way of non-limitative example in conjunction with the drawings, in which:
- Figures 1a and 1b show in plan view and in sectional view, respectively, a first embodiment of the invention;
- Figures 2a and 2b show in plan view and in sectional view, respectively, a second embodiment of the invention;
- Figures 3a and 3b show a preferred embodiment of the invention;
- and Figure 4 shows a third embodiment of the invention.

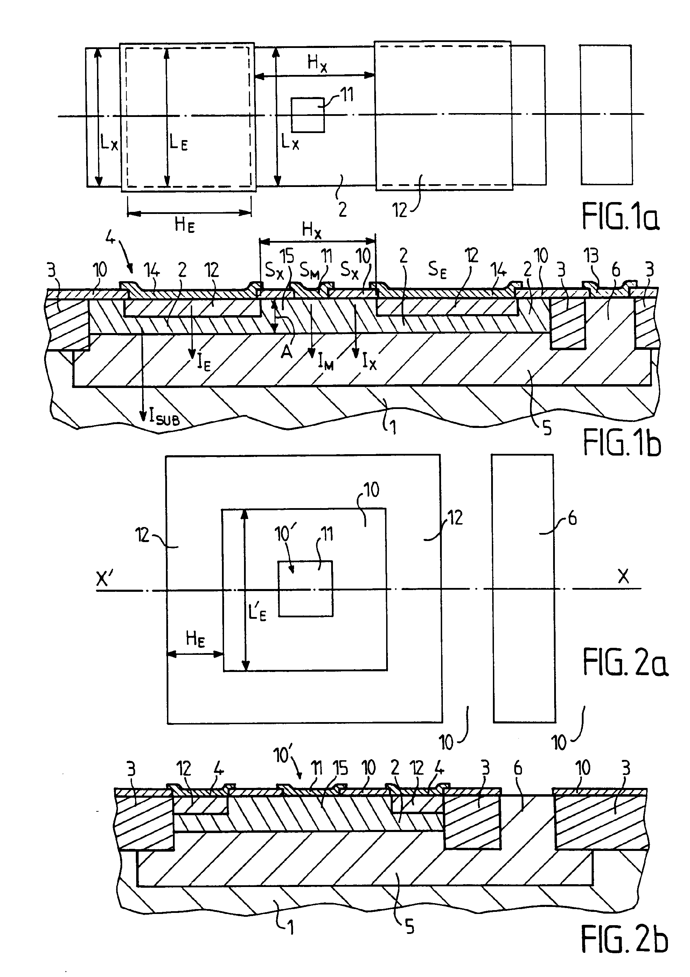

According to Figures 1a and 1b, an integrated circuit in accordance with the invention comprises a p-type substrate 1, on which a buried n⁺ layer 5 forming the collector of the vertical transistor and then a p-type base region 2 are provided. The buried layer 5 and the base region 2 may be formed by epitaxial growth on the substrate 1

A layer 3 of deep oxide limits on the one hand a first island 4 for the vertical transistor and on the other hand a second n⁺ island 6 for collector contacting on the major surface of the circuit. The layer 3 of deep oxide is slightly deeper than the epitaxial base layer 2.

Into the base region 2 are diffused two n-type emitter zones 12, which are separated from each other and form the emitter region of the transistor.

The zone 15 of the base 2 situated between the two zones 12 serves for base contacting. The part of the base region 2 beneath the emitter zones 12 constitutes the active base. An isolating layer 10, for example a thin oxide layer, formed on the whole surface of the integrated circuit has windows, through which the emitter zones 12 and the collector region 6 are contacted by a conductive layer 14, 13, and windows 10′ through which the base region 2 is contacted by a conductive layer 11.

The base region 2 is such that its overall thickness A, which in this case corresponds approximately to the thickness of the epitaxial layer, is smaller than or equal to the diffusion length of the minority charge carriers in these regions.

In this case, the Inventor has been able to recognize that the phenomenon of vertical injection can be modelled in a manner quite different from the conventional theories.

In the inverse mode of operation, the collector-base junction is forward-biased, while the emitter-base is either reverse-biased or at zero voltage. The inverse amplification β_{I} is the ratio between the emitter current I_{E} and the base current I_{B}.

The two zones 12 forming the emitter each have a width H_{E}, a length L_{E} and a surface area S_{E}.

The base region 2 adjoins at region 15 the major surface of the circuit, of which a part lying under the base window has a surface S_{M} and of which the other part situated under the isolating layer 10 has a surface Sₓ. This region 15 forms a base contacting region.

The injected currents are represented in Figure 1b and their values partly depend upon the base-collector voltage V_{B}C and upon the dimension of the relevant zones.

The emitter current has the value:${\text{I}}_{\text{E}} {\text{= 2 S}}_{\text{E}} \text{Jo(e} \frac{{\text{V}}_{\text{Bc}}}{{\text{V}}_{\text{T}}} \text{)}$
e = exponential

The current I_{M} injected under the base contact (injection under metal) has the value:${\text{I}}_{\text{M}} {\text{= S}}_{\text{M}} {\text{J}}_{\text{M}} \text{(e} \frac{{\text{V}}_{\text{Bc}}}{{\text{V}}_{\text{T}}} \text{-1)}$

The current Iₓ injected under the oxide covering the base has the value:${\text{I}}_{\text{x}} {\text{= S}}_{\text{x}} {\text{J}}_{\text{x}} \text{(e} \frac{{\text{V}}_{\text{Bc}}}{{\text{V}}_{\text{T}}} \text{-1)}$

The current I_{sub} to the substrate has the value:${\text{I}}_{\text{sub}} {\text{= J}}_{\text{s}} {\text{(2S}}_{\text{E}} {\text{+S}}_{\text{x}} {\text{+S}}_{\text{M}} \text{)(e} \frac{{\text{V}}_{\text{Bc}}}{{\text{V}}_{\text{T}}} {\text{-1)≈J}}_{\text{s}} {\text{(2S}}_{\text{E}} {\text{+S}}_{\text{x}} \text{)(e} \frac{{\text{V}}_{\text{Bc}}}{{\text{V}}_{\text{T}}} \text{- 1)}$
J₀,J_{M},Jₓ and Jₛ designate the current densities injected into the emitter, under a metallic layer into the base region, under an oxide layer into the base region and to the substrate, respectively.

The recombination current in the buried layer 5 is neglected.

An example is:$\text{J₀ = 500.10⁻²¹A/µm²}$${\text{J}}_{\text{M}} \text{= 50.10⁻²¹A/µm²}$${\text{J}}_{\text{x}} \text{= 1,3.10⁻²¹A/µm²}$${\text{J}}_{\text{s}} \text{= 3,5.10⁻²¹A/µm²}$

Assuming e$\frac{{\text{V}}_{\text{Bc}}}{{\text{V}}_{\text{T}}}$ » 1 and V_{T} = 26 mV,
the inverse current amplification can be expressed as:${\text{β}}_{\text{I}} \text{=} \frac{{\text{I}}_{\text{E}}}{{\text{I}}_{\text{B}}} \text{=} \frac{{\text{2S}}_{\text{E}} \text{J₀}}{{\text{S}}_{\text{x}} {\text{J}}_{\text{x}} {\text{+ S}}_{\text{M}} {\text{J}}_{\text{M}} {\text{+ (2S}}_{\text{E}} {\text{+S}}_{\text{x}} {\text{)J}}_{\text{s}}}$
with I_{B} = Iₓ + Iₘ + I_{sub}
From this equation results that, in order to have a high value of β_{I}, it is necessary that the surface S_{M} is as small as possible, because the preponderant term of the denominator is the term of J_{M}, which in this case largely exceeds Jₓ and Jₛ, and it is also necessary that Sₓ is small with respect to S_{E}.

The inverse of the amplification 1/β_{I} can be expressed as:$\frac{\text{1}}{{\text{β}}_{\text{I}}} \text{=} \frac{{\text{S}}_{\text{x}} {\text{(J}}_{\text{x}} {\text{+J}}_{\text{s}} {\text{) + S}}_{\text{M}} {\text{J}}_{\text{M}} {\text{+ 2S}}_{\text{E}} {\text{J}}_{\text{s}}}{{\text{2S}}_{\text{E}} {\text{J}}_{\text{o}}}$$\frac{\text{1}}{{\text{β}}_{\text{I}}} \text{=} \frac{{\text{S}}_{\text{x}}}{{\text{2S}}_{\text{E}}} \frac{{\text{(J}}_{\text{x}} {\text{+ J}}_{\text{s}} \text{)}}{{\text{J}}_{\text{o}}} \text{+} \frac{{\text{S}}_{\text{M}}}{{\text{2S}}_{\text{E}}} \frac{{\text{J}}_{\text{M}}}{{\text{J}}_{\text{o}}} \text{+} \frac{{\text{J}}_{\text{s}}}{{\text{J}}_{\text{o}}}$
i.e. with the numerical values of Jₛ, Jₓ, J_{M} and J₀ given above:$\frac{\text{1}}{{\text{β}}_{\text{I}}} \text{=} \frac{\text{1}}{\text{100}} \text{(0,7 + 0,48} \frac{{\text{S}}_{\text{x}}}{{\text{S}}_{\text{E}}} \text{+ 5} \frac{{\text{S}}_{\text{M}}}{{\text{S}}_{\text{E}}} \text{)}$

It appears that, for S_{M} ≦ 1/10 Sₓ, the last term has a weight smaller than or equal to that of the foregoing but one. It is also necessary that the ratio Sₓ/S_{E} is chosen small in order that the value of the amplification β₁ is sufficiently high.

The base contacting zone must therefore have a surface area smaller than approximately 5 times the total area of the emitter (2 S_{E} in the example given above).

Let it be assumed that:
H_{E} = width of an emitter zone,
L_{E} = length of an emitter zone,
Hₓ = width leaving room for a base contact,
Lₓ = length of a base contact zone.

Let it be assumed that Sₓ = Hₓ Lₓ (for S_{M} < <Sₓ);
let it be assumed that Hₓ has the minimum value permitted by the method, for example 14 µm.
Let it be assumed that L_{E} ≈ Lₓ = 25 µm and S_{M} = 10 µm².
Then there is:$\frac{\text{1}}{{\text{β}}_{\text{I}}} \text{=} \frac{\text{1}}{\text{100}} \text{(0,7 +} \frac{\text{9}}{{\text{H}}_{\text{E}}} \text{)}$
Then the variation of β_{I} as a function of H_{E} is obtained.

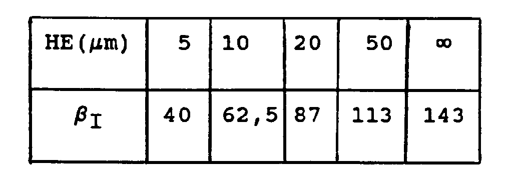

In the above example, an emitter width H_{E} equal to 10 µm guarantees an inverse amplification β_{I} exceeding 50.

For H_{E} = 10 µm and L_{E} ≈ Lₓ, the influence of L_{E} is considered.
There is:$\frac{\text{1}}{{\text{β}}_{\text{I}}} \text{=} \frac{\text{1}}{\text{100}} \text{(1,4 +} \frac{\text{5}}{{\text{L}}_{\text{E}}} \text{)}$

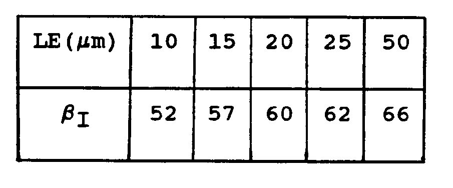

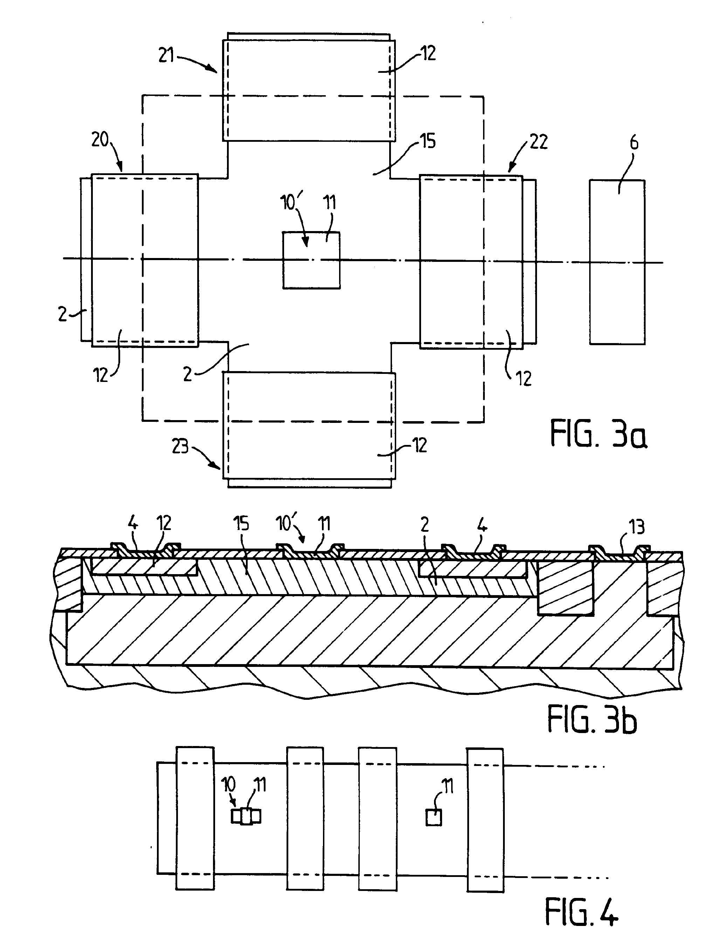

The length L_{E} of the emitter zones has much less influence than the width of said zones. This shows that a very favourable form is that of elongated emitters. This is logical because, when L_{E} is increased, Sₓ also increases. Now the ratio of the surfaces is preponderant. The best results for β_{I} are therefore obtained for S_{M}, L_{E} and Lₓ having the minimum value permitted by the method, and H_{E} has the highest possible value attainable in practice, which corresponds to a form of transistor having elongated emitters in one or several favourable directions. Figures 3a and 3b also show a structure in the form of a cross of four branches (20 to 23) having an emitter region comprising four zones 12 interconnected by a metallization strip indicated by a dotted line.

Another favourable form corresponds to the case shown in Figures 2a and 2b, in which the emitter has the form of a belt closed in itself and entirely surrounding the base which has the minimum sides permitted by the method, i.e. for example:${\text{S}}_{\text{M}} \text{= 10 µm²}$${\text{S}}_{\text{x}} \text{= 120 µm²}$${\text{H}}_{\text{E}} \text{= 10 µm}$
where:${\text{L′}}_{\text{E}} \text{= 11 µm}$

The surface of the emitter then has the value:${\text{S}}_{\text{E}} {\text{= 4L′}}_{\text{E}} {\text{H}}_{\text{E}} {\text{+ 4H}}_{\text{E}} \text{= 840 µm²} \text{=} \frac{\text{1}}{{\text{β}}_{\text{I}}} \text{=} \frac{{\text{S}}_{\text{x}} {\text{J}}_{\text{x}} {\text{+ S}}_{\text{M}} {\text{J}}_{\text{M}} {\text{+ (S}}_{\text{E}} {\text{+ S}}_{\text{x}} {\text{+ S}}_{\text{m}} {\text{) J}}_{\text{s}}}{{\text{S}}_{\text{E}} {\text{J}}_{\text{o}}} \text{,}$
rendering$\frac{\text{1}}{{\text{β}}_{\text{I}}} \text{=} \frac{{\text{J}}_{\text{s}}}{{\text{J}}_{\text{o}}} \text{+} \frac{{\text{(J}}_{\text{x}} {\text{J}}_{\text{s}} \text{)}}{{\text{J}}_{\text{o}}} \frac{{\text{S}}_{\text{x}}}{{\text{S}}_{\text{E}}} \text{+} \frac{{\text{J}}_{\text{M}} {\text{+ J}}_{\text{s}}}{{\text{J}}_{\text{o}}} \frac{{\text{S}}_{\text{m}}}{{\text{S}}_{\text{E}}} \text{≈} \frac{{\text{J}}_{\text{s}}}{{\text{J}}_{\text{o}}} \text{+} \frac{{\text{J}}_{\text{x}} {\text{J}}_{\text{s}}}{{\text{J}}_{\text{o}}} \frac{{\text{S}}_{\text{x}}}{{\text{S}}_{\text{E}}} \text{+} \frac{{\text{J}}_{\text{M}}}{{\text{J}}_{\text{o}}} \frac{{\text{S}}_{\text{m}}}{{\text{S}}_{\text{E}}}$
This yields a value of about β_{I} = 106, with the values of Jₛ, J_{M} and J₀ given hereinbefore by way of example.

Also this structure yields therefore a high amplification. It moreover has a lower base resistance, and a lower value with equal amplification of the lower value with equal amplification of the junction capacitance, which renders this structure particularly advantageous.

A variation shown in Figure 4 comprises a plurality of structures arranged in parallel having alternately an emitter zone, a base zone, two emitter zones, a base zone, etc. Another form having a lower inverse amplification consists in the alternation of an emitter zone and of a base zone.

The invention is not limited to the embodiments described and shown. In particular, although it has been described for the case of npn transistors, it may also be used for pnp transistors.

## Claims

1. A semiconductor device comprising a semiconductor body having a major surface and having an integrated circuit having a vertical transistor comprising a collector region (5) of a first conductivity type, a base region (2) of a second conductivity type disposed on at least a part of the collector region (5) and an emitter region composed of at least one zone (12) of the first conductivity type included in a part of said base region (2) and adjoining said major surface of the semiconductor body, characterized in that the overall thickness of the base region (2) is smaller than or equal to the diffusion length of the minority charge carriers in said base region (2), in that said base region (2) comprises at least one base contacting zone (15) having at least one contact area adjacent to the said at least one zone (12) of the emitter region, said base contacting zone (15) being covered by an isolating layer (10) having a window (10′), through which a contact (11) is provided to said contact area, the ratio between the surface area of said base contacting zone (15) and the surface area of said window (10′) being at least equal to 10, and in that said base contacting zone (15) has a surface area smaller than 5 times the total surface area of said emitter region.

2. An integrated circuit as claimed in Claim 1,
characterized in that said contact area is surrounded by a single zone (12) constituting the emitter region.

3. An integrated circuit as claimed in Claim 1,
characterized in that the emitter region is composed of at least two zones (12) facing each other and flanking at least one portion of the said base contacting zone (15).

4. An integrated circuit as claimed in Claim 3,
characterized in that the base region has at least two base contacting zones (15) and the emitter region comprises at least two pairs of zones (12), the two zones (12) of each pair flanking a different one of the base contacting zones (15).

5. An integrated circuit as claimed in Claim 1,
characterized in that the base region comprises a plurality of branches (20-23) linked by a central region with respect to said branches (20-23), each branch (20-23) comprising a zone (12) of the emitter region, and in that said contact area of said base contacting zone (15) is provided in said central region.

## Patentansprüche

1. Halbleiteranordnung, die einen Halbleiterkörper mit einer Hauptfläche und einer integrierten Schaltung mit einem vertikalen Transistor umfaßt, wobei dieser Transistor ein Kollektorgebiet eines ersten Leitungstyps umfaßt, ein wenigstens auf einem Teil des Kollektorgebiets (5) liegendes Basisgebiet (2) eines zweiten Leitungstyps und ein Emittergebiet, das wenigstens aus einer Zone (12) des ersten Leitungstyps besteht, wobei diese Zone in einem Teil des genannten Basisgebiets (2) enthalten ist und an die genannte Hauptfläche des Halbleiterkörpers grenzt, dadurch gekennzeichnet, daß die Gesamtdicke des Basisgebiets (2) kleiner oder gleich der Diffusionslänge der Minoritätsträger in dem genannten Basisgebiet (2) ist, daß das genannte Basisgebiet (2) wenigstens eine Basiskontaktzone (15) mit wenigstens einer Kontaktfläche umfaßt, die an die wenigstens eine Zone (12) des genannten Emittergebiets grenzt, wobei die genannte Basiskontaktzone (15) mit einer Isolationsschicht (10) mit einem Fenster (10′) bedeckt ist, wodurch ein Kontakt (11) mit der genannten Kontaktfläche hergestellt wird, wobei das Verhältnis zwischen der Oberfläche der Basiskontaktzone (15) und der Oberfläche des genannten Fensters (10') wenigstens gleich 10 ist und dadurch, daß die genannte Basiskontaktzone (15) eine Oberfläche hat, die mehr als fünf mal kleiner ist als die Gesamtoberfläche des genannten Emittergebiets.

2. Integrierte Schaltung nach Anspruch 1, dadurch gekennzeichnet, daß die genannte Kontaktfläche von einer einzelnen das Emittergebiet bildenden Zone (12) umgeben ist.

3. Integrierte Schaltung nach Anspruch 1, dadurch gekennzeichnet, daß das Emittergebiet aus wenigstens zwei Zonen (12) zusammengesetzt ist, die einander gegenüberliegen und an wenigstens einem Teil der Basiskontaktzone (15) anliegen.

4. Integrierte Schaltung nach Anspruch 3, dadurch gekennzeichnet, daß das Basisgebiet wenigstens zwei Basiskontaktzonen (15) hat und das Emittergebiet wenigstens zwei Paare von Zonen (12) hat, wobei die beiden Zonen (12) jedes Paares an jeweils einer anderen Basiskontaktzone (15) anliegen.

5. Integrierte Schaltung nach Anspruch 1, dadurch gekennzeichnet, daß das Basisgebiet eine Vielzahl Teilzonen (20-23) umfaßt, die durch ein relativ zu diesen Teilzonen zentral liegendes Gebiet verbunden sind, wobei jede Teilzone (20-23) eine Zone (12) des Emittergebiets umfaßt, und daß die genannte Kontaktfläche der genannten Basiskontaktzone (15) in dem genannten zentralen Gebiet liegt.

## Revendications

1. Dispositif semiconducteur comportant un corps semiconducteur présentant une surface principale et pourvu d'un circuit intégré présentant un transistor vertical comportant une région de collecteur d'un premier type de conductivité, une région de base (2) d'un second type de conductivité disposée sur au moins une partie de la région de collecteur (5) et une région d'émetteur constituée d'au moins une zone (12) du premier type de conductivité incluse dans une partie de ladite région de base (2) et contiguë à ladite surface principale du corps semiconducteur, caractérisé en ce que l'épaisseur totale de la région de base (2) est inférieure ou égale à la longueur de diffusion des porteurs minoritaires dans ladite région de base (2), en ce que ladite région de base (2) comporte au moins une zone de prise de contact de base (15) comprenant au moins une plage de contact jouxtant ladite zone (12) de la région d'émetteur, cette zone de prise de contact de base (15) étant recouverte d'une couche isolante (10) présentant une fenêtre (10′) à travers laquelle est prévu un contact (11) avec ladite zone de prise de contact, le rapport entre la surface de ladite zone de prise de contact de base (15) et celle de ladite fenêtre (10') étant au moins égal à 10, et en ce que ladite zone de prise de contact de base (15) a une surface inférieure à 5 fois celle de ladite région d'émetteur.

2. Circuit intégré selon la revendication 1, caractérisé en ce que ladite zone de prise de contact est entourée par une zone unique (12) constituant la région d'émetteur.

3. Circuit intégré selon la revendication 1, caractérisé en ce que la région d'émetteur est constituée d'au moins deux zones opposées encadrant au moins une partie de ladite zone de prise de contact de base (15).

4. Circuit intégré selon la revendication 3, caractérisé en ce que la région de base présente au moins deux zones de prise de contact de base (15) et la région d'émetteur présente au moins deux paires de zones (12), les deux zones (12) de chaque paire étant en vis-à-vis et encadrant chacune desdites zones de prise de contact de base (15).

5. Circuit intégré selon la revendication 1, caractérisé en ce que la région de base comporte une pluralité de branches (20-23) couplées par une région centrale par rapport auxdites branches (20-23), chaque branche (20-23) comportant une zone (12) de la région d'émetteur, et en ce que ladite plage de contact de ladite zone de prise de contact de base (15) est disposée dans ladite région centrale.
